# FASCICULE DE BREVET EUROPEEN

(11) **EP 2 286 251 B1**
(45) Date de publication et mention de la délivrance du brevet: **08.08.2018**
(21) Numéro de dépôt: 09757580.7
(22) Date de dépôt: 04.06.2009
(51) Int. Cl.: G01R 27/32, G01R 35/00

(54) **PROCÈDE DE CALIBRAGE TRL POUR BOÎTIER HYPERFRÉQUENCE ET ENSEMBLE DE BOÎTIERS ÉTALONS**
TRL-KALIBRIERUNGSVERFAHREN FÜR EIN MIKROWELLENMODUL UND SATZ VON STANDARDMODULEN DAFÜR
TRL CALIBRATION METHOD FOR A MICROWAVE MODULE AND A SET OF STANDARD MODULES

(30) Priorité: 06.06.2008 FR 0803172
(43) Date de publication de la demande: 23.02.2011
(73) Titulaire: THALES, 92400 Courbevoie (FR)
(72) Inventeur: BARBIER, Thierry, F-78280 Guyancourt (FR); CABAN-CHASTAS, Daniel, F-92310 Sevres (FR); RANANJASON, Valérie, F-78370 Plaisir (FR); TEMPEZ, Gérard, F-78690 Les Essarts Le Roi (FR)
(74) Mandataire: Lucas, Laurent Jacques
(86) Numéro de dépôt international: PCT/EP2009/056855
(87) Numéro de publication internationale: WO 2009/147199

(56) Documents cités:
- EP-A- 0 626 588
- US-A- 4 535 307
- US-A1- 2004 051 538
- US-A1- 2006 056 310

## Description

La présente invention concerne un procédé de calibrage d'une plate-forme de test apte à recevoir un boîtier hyperfréquence. Elle s'applique notamment à des boîtiers hyperfréquences dont l'interface électrique avec le circuit imprimé sur lequel ils sont implantés est du type matrice de billes. L'invention concerne également un ensemble de boîtiers étalons hyperfréquences aptes à être connectés sur la plate-forme de test. L'invention concerne enfin un procédé de détermination d'une longueur électrique d'une ligne gravée d'un boîtier étalon hyperfréquence.

Un boîtier hyperfréquence a pour principale fonction de protéger de l'environnement électromagnétique extérieur un composant hyperfréquence qu'il renferme. A cet effet, les parois intérieures du boîtier peuvent être recouvertes d'une surface conductrice formant une masse, cette masse étant généralement reliée à la masse du circuit imprimé sur lequel est monté le boîtier. Un boîtier hyperfréquence a pour autre fonction de protéger le composant hyperfréquence de l'environnement physique extérieur, notamment de l'humidité. A cet effet, le boîtier peut être fermé de manière hermétique, un gaz inerte, par exemple de l'argon, étant enfermé dans le boîtier.

Un boîtier hyperfréquence peut être de type matrices de broches, matrices de pastilles ou de type matrice de billes. Les boîtiers de type matrices de broches, mieux connus sous la dénomination de "boîtiers PGA", PGA étant l'acronyme de l'expression anglo-saxonne "Pin Grid Array", comportent des points de connexion réalisés sous forme de broches disposées sur la face inférieure du boîtier le long de périmètres concentriques. Les boîtiers de type matrices de pastilles, mieux connus sous la dénomination de "boîtiers LGA", LGA étant l'acronyme de l'expression anglo-saxonne "Land Grid Array", comportent des points de connexion réalisés sous forme de pastilles disposées sur la face inférieure du boîtier de manière matricielle ou sur le périmètre du boîtier. Les boîtiers de type matrice de billes, mieux connus sous la dénomination de boîtiers "BGA", BGA étant l'acronyme de la dénomination anglo-saxonne "Ball Grid Array", comprennent des billes de connexion disposées de manière matricielle sur la surface inférieure du boîtier. Les billes sont réalisées en matériau fusible ou non fusible, par exemple un mélange étain-plomb. De manière connue, une telle matrice de billes permet de réaliser le contact électrique des différents points de connexion du boîtier avec le circuit imprimé sur lequel le boîtier est monté, et assure l'assemblage du boîtier au circuit imprimé. A cet effet, le circuit imprimé porte des empreintes métalliques dans un arrangement identique à l'arrangement des billes. Les billes et les empreintes sont placées en vis-à-vis et l'ensemble comprenant le boîtier et le circuit imprimé est chauffé de façon à entraîner la fusion d'un alliage de brasure servant à la fixation du boîtier sur le circuit imprimé, et éventuellement la fusion des billes en fonction de leur composition.

Comme tout composant électronique en général, et tout composant hyperfréquence en particulier, un boîtier hyperfréquence nécessite d'être caractérisé, notamment pour la conception et/ou la modélisation de circuits électroniques intégrant un tel boîtier hyperfréquence.

Selon une première solution, les caractéristiques d'un boîtier hyperfréquence sont déterminées de la façon suivante. Dans une première étape, on détermine un modèle de simulation des caractéristiques de l'environnement, par exemple sous forme d'une matrice de paramètres S. Dans une deuxième étape, on mesure à l'aide d'un analyseur de réseau vectoriel les caractéristiques du boîtier dans son environnement, par exemple une plate-forme de test reliée à l'analyseur de réseau vectoriel par des câbles coaxiaux. Les caractéristiques du boîtier dans son environnement sont par exemple modélisées sous forme de matrice de paramètres S. A partir des deux matrices de paramètres S, on en déduit dans une troisième étape la matrice de paramètres S du boîtier seul en retranchant par calcul la matrice de paramètres S de l'environnement à la matrice de paramètres S du boîtier mesuré dans son environnement. Cette détermination des caractéristiques d'un boîtier hyperfréquence présente plusieurs inconvénients. Un premier inconvénient résulte du fait que les caractéristiques du boîtier seul sont déduites conjointement à partir d'un modèle et d'une mesure, rendant nécessaire la modélisation de l'environnement en plus de la mesure du boîtier dans son environnement. Un deuxième inconvénient est que l'environnement peut comporter des éléments difficilement modélisables tels que des connecteurs hyperfréquences et des supports de transmission non coaxiaux. L'interface entre le boîtier et l'environnement peut également être difficilement modélisable. C'est notamment le cas pour des boîtiers de type BGA. Par conséquent, la modélisation de l'environnement peut être imprécise, faussant ainsi les caractéristiques déduites du boîtier hyperfréquence.

Selon une deuxième solution, les caractéristiques de l'environnement ne sont plus simulées mais déterminées par un procédé de calibrage consistant essentiellement à mesurer l'environnement de test en présence de différents motifs étalons disposés successivement sur une plate-forme de test et à en déduire les caractéristiques de l'environnement de test seul. Ce procédé de calibrage est appelé calibrage TRL. Les motifs étalons comprennent un motif appelé motif Thru, un motif appelé motif Reflect et un ou plusieurs motifs appelés motifs Line. Selon le calibrage TRL, la plate-forme de test est constituée de deux parties détachables supportant chacune une ligne microruban connectée à un connecteur de câble coaxial. Les deux parties peuvent être jointes afin de relier les extrémités libres des lignes microrubans. Cette configuration permet un passage direct d'un signal hyperfréquence entre les deux parties et donne son nom au motif Thru. Alternativement, le motif Thru est réalisé par une ligne microruban relativement courte insérée entre les deux parties. Le motif Reflect est obtenu soit en séparant simplement les deux parties de la plate-forme de test, soit en réalisant un court-circuit aux extrémités libres des lignes microrubans. Dans les deux cas, le signal hyperfréquence est réfléchi aux extrémités libres des lignes microrubans. Le motif Line est réalisé par une ligne microruban de longueur supérieure à celle du motif Thru. Connaissant les matrices de paramètres S pour les différents motifs et la longueur électrique des lignes microrubans des motifs Thru et Line, généralement obtenues par simulation, il est possible de déduire les caractéristiques de la plate-forme de test. Un boîtier hyperfréquence peut alors être caractérisé en le connectant aux extrémités libres des lignes microrubans. Pour une présentation plus développée du calibrage TRL et de son modèle mathématique, on pourra notamment se reporter à Engen, G.F., Hoer C.A., "Thru-Reflect-Line: An Improved Technique for Calibrating the Dual Six-Port Automatic Network Analyzer", IEEE Trans. Microwave Theory and Techniques, December 1979. Cependant, cette solution souffre de plusieurs inconvénients. Tout d'abord, la configuration de la plate-forme de test est modifiée aux cours des différentes mesures, modifiant par là même ses caractéristiques. De plus, la connexion entre les lignes microrubans de la plate-forme de test et les accès hyperfréquences du boîtier est différente de la connexion entre ces lignes microrubans et les motifs étalons. Ces deux constatations montrent d'une part que le calibrage TRL introduit des erreurs de calibrage, et d'autre part qu'il n'est pas adapté au test de boîtiers hyperfréquences.

Un document US2006/056310 A1 décrit une méthode de détermination des caractéristiques d'un composant. Un document EP 0 626 588 A divulgue un système configurable permettant de calibrer un analyseur de réseau vectoriel. Un document US2004/051538 A1 divulgue une méthode de calibration d'adaptateurs pour la détermination des paramètres S d'un composant. Un document US 4 535 307 A divulgue une plate-forme de test.

Un but de l'invention est notamment de pallier tout ou partie des inconvénients précités. A cet effet, l'invention a pour objet un procédé de calibrage d'une plate-forme de test apte à recevoir un boîtier hyperfréquence, caractérisé en ce qu'il comprend les étapes suivantes :
- déterminer une première matrice de paramètres S, un premier boîtier hyperfréquence dont les accès hyperfréquences sont reliés par une ligne gravée de longueur L_{Thru} étant connecté à la plate-forme de test ;
- déterminer une deuxième matrice de paramètres S, un deuxième boîtier hyperfréquence dont les accès hyperfréquences sont court-circuités étant connecté à la plate-forme de test ;
- déterminer une troisième matrice de paramètres S, un troisième boîtier hyperfréquence dont les accès hyperfréquences sont reliés par une ligne gravée de longueur L_{Line} supérieure à la longueur L_{Thru} étant connecté à la plate-forme de test ;
- une étape de détermination, à partir des première, deuxième et troisième matrices de paramètres S, des caractéristiques de la plate-forme de test.

Selon une forme particulière de réalisation, le boîtier hyperfréquence à tester comprend un composant hyperfréquence relié à deux accès hyperfréquences, les accès hyperfréquences des premier, deuxième et troisième boîtiers hyperfréquences étant identiques aux accès hyperfréquences du boîtier hyperfréquence à tester.

Selon une forme particulière de réalisation, les boîtiers hyperfréquences comportent une interface à matrice de billes.

Selon une forme particulière de réalisation, la connexion électrique entre les boîtiers hyperfréquences et la plate-forme de test est assurée par pression.

L'invention a également pour objet un ensemble de boîtiers étalons hyperfréquences aptes à être connectés sur une plate-forme de test d'un boîtier hyperfréquence, ledit boîtier hyperfréquence comprenant un composant hyperfréquence relié à deux accès hyperfréquences. Selon l'invention, l'ensemble de boîtiers étalons comprend :
- un premier boîtier hyperfréquence dont les accès hyperfréquences sont reliés par une ligne gravée de longueur L_{Thru},
- un deuxième boîtier hyperfréquence dont les accès hyperfréquences sont court-circuités,
- un troisième boîtier hyperfréquence dont les accès hyperfréquences sont reliés par une ligne gravée de longueur L_{Line} supérieure à la longueur L_{Thru},
- les accès hyperfréquences des premier, deuxième et troisième boîtiers hyperfréquences étant identiques aux accès hyperfréquences du boîtier hyperfréquence à tester.

Selon une forme particulière de réalisation, les boîtiers hyperfréquences comprennent une interface à matrice de billes.

L'invention s'appuie notamment sur le fait que la plate-forme de test est utilisée à la fois pour accueillir les boîtiers étalons servant à la caractériser et les boîtiers hyperfréquences à mesurer. L'invention a notamment pour avantage qu'elle permet de mesurer les caractéristiques du boîtier au niveau de son interface avec la plate-forme de test. Ces caractéristiques peuvent ensuite être exploitées dans un simulateur pour simuler le comportement du boîtier dans un environnement différent de celui dans lequel il a été mesuré.

L'invention a encore pour objet un procédé de détermination d'une longueur électrique L_{C} d'une ligne gravée reliant deux accès hyperfréquences d'un boîtier étalon hyperfréquence, les accès hyperfréquences du boîtier étalon étant aptes à être connectés à une première et à une deuxième interfaces internes d'une plate-forme de test, la plate-forme de test comprenant une première ligne hyperfréquence entre une première interface externe et la première interface interne et une deuxième ligne hyperfréquence entre une deuxième interface externe et la deuxième interface interne. Le procédé selon l'invention comprend les étapes suivantes :
- déterminer une première longueur électrique de la première ligne hyperfréquence de la plate-forme de test ;
- déterminer une deuxième longueur électrique de la deuxième ligne hyperfréquence de la plate-forme de test ;
- déterminer une troisième longueur électrique correspondant à la longueur électrique entre les interfaces externes de la plate-forme de test et incluant la longueur électrique de la ligne gravée reliant les deux accès hyperfréquences du boîtier étalon ;
- déduire des première, deuxième et troisième longueurs électriques, la longueur électrique de la ligne gravée ;
la détermination de la première longueur électrique comprenant les sous-étapes suivantes :
- déterminer une longueur électrique entre un instrument de mesure et la première interface externe de la plate-forme de test ;
- déterminer une longueur électrique entre l'instrument de mesure et la première interface interne de la plate-forme de test ;
- déduire des longueurs électriques entre, d'une part, l'instrument de mesure et la première interface externe de la plate-forme de test et, d'autre part, l'instrument de mesure et la première interface interne de la plate-forme de test, la première longueur électrique ;
la détermination de la longueur électrique entre l'instrument de mesure et la première interface interne de la plate-forme de test comprenant une étape consistant à connecter aux interfaces internes de la plate-forme de test un boîtier hyperfréquence dont les accès hyperfréquences sont court-circuités.

Selon une forme particulière de réalisation, la détermination de la deuxième longueur électrique comprend les sous-étapes suivantes :
- déterminer une longueur électrique entre un instrument de mesure et la deuxième interface externe de la plate-forme de test ;
- déterminer une longueur électrique entre l'instrument de mesure et la deuxième interface interne de la plate-forme de test ;
- déduire des longueurs électriques entre, d'une part, l'instrument de mesure et la deuxième interface externe de la plate-forme de test et, d'autre part, l'instrument de mesure et la deuxième interface interne de la plate-forme de test, la deuxième longueur électrique.

Selon une forme particulière de réalisation, la détermination de la longueur électrique entre l'instrument de mesure et une interface externe de la plate-forme de test comprend une étape consistant à disposer un motif réfléchissant à une extrémité d'un câble coaxial devant être connectée à ladite interface externe de la plate-forme de test.

Selon une forme particulière de réalisation, la détermination de la longueur électrique entre l'instrument de mesure et une interface interne de la plate-forme de test comprend une étape consistant à connecter aux interfaces internes de la plate-forme de test un boîtier hyperfréquence dont les accès hyperfréquences sont court-circuités.

Selon une forme particulière de réalisation, la détermination de la troisième longueur électrique comprend les sous-étapes suivantes :
- déterminer une longueur électrique entre un instrument de mesure et la deuxième interface externe de la plate-forme de test, ladite longueur incluant la longueur électrique de la ligne gravée ;
- déterminer une longueur électrique entre l'instrument de mesure et la première interface externe de la plate-forme de test ;
- déduire de la longueur électrique entre l'instrument de mesure et la deuxième interface externe de la plate-forme de test et de la longueur électrique entre l'instrument de mesure et la première interface externe de la plate-forme de test, la troisième longueur électrique.

Ce procédé présente l'avantage de permettre une détermination précise de la longueur électrique de la ligne gravée. Ceci est notamment dû au fait que la longueur électrique de la ligne gravée est obtenue par mesure et non par simulation.

L'invention sera mieux comprise et d'autres avantages apparaîtront à la lecture de la description détaillée d'un mode de réalisation donné à titre d'exemple, description faite en regard de dessins annexés qui représentent :
- la figure 1, un boîtier hyperfréquence à tester et son environnement de test ;
- la figure 2, un premier boîtier étalon hyperfréquence ;
- la figure 3, un deuxième boîtier étalon hyperfréquence ;
- la figure 4, un troisième boîtier étalon hyperfréquence ;
- la figure 5, un boîtier étalon hyperfréquence dont on cherche à déterminer une longueur électrique d'une ligne gravée et son environnement de test.

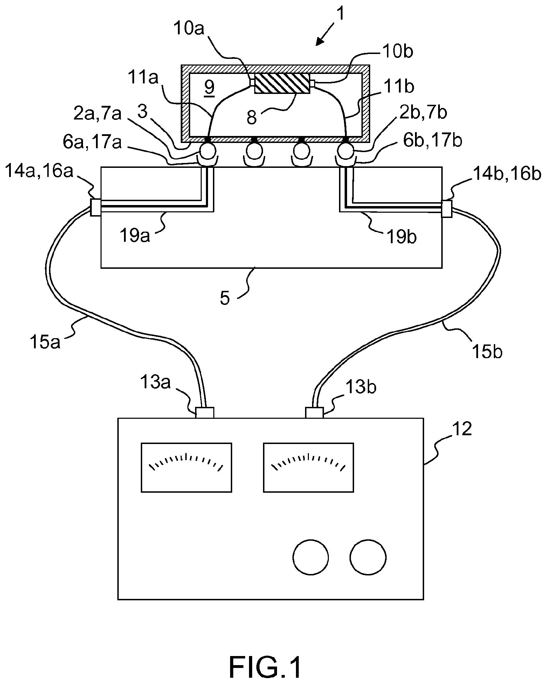

La figure 1 représente schématiquement un boîtier 1 hyperfréquence dont on cherche à déterminer les caractéristiques dans son environnement de test. Ces caractéristiques sont par exemple modélisées sous forme d'une matrice de paramètres S. Le boîtier 1 est par exemple un boîtier à matrice de billes ou boîtier BGA. La suite de la description est faite en considération d'un boîtier BGA, cependant, tout type de boîtier, par exemple un boîtier à matrice de broches ou un boîtier à matrice de pastilles, peut être considéré sans sortir du cadre de l'invention. Le boîtier 1 comprend des billes portant la référence générique 2 et agencées sur une face 3 du boîtier 1 de façon à former une matrice de billes. Cette matrice de billes forme une interface électrique avec une plate-forme de test 5 et en particulier avec des empreintes conductrices réalisées sur la plate-forme de test 5 et portant la référence générique 6. Deux des billes 2, portant les références 2a, 2b, peuvent en particulier être utilisées pour conduire un signal hyperfréquence, notamment des signaux hyperfréquences de test. Ces billes 2a et 2b forment des accès hyperfréquences 7a et 7b du boîtier 1 et sont en contact avec la plate-forme de test 5 par l'intermédiaire d'empreintes conductrices 6a et 6b. Les autres billes 2 du boîtier 1 sont généralement reliées à un plan de masse, par exemple le plan de masse de la plate-forme de test 5, par l'intermédiaire des empreintes conductrices 6. Le boîtier 1 hyperfréquence peut comporter un composant 8 hyperfréquence encapsulé dans une cavité 9 du boîtier 1. Le composant 8 hyperfréquence comporte par exemple deux ports, un port d'entrée 10a et un port de sortie 10b. Chaque port 10a, 10b peut être relié aux accès hyperfréquences 7a, 7b, par exemple par l'intermédiaire de fils de connexion 11a, 11b connectés à des lignes hyperfréquences elles-mêmes en contact avec les billes 2a et 2b. La plate-forme de test 5 est reliée à un instrument de mesure 12, par exemple un analyseur de réseau vectoriel, permettant de déterminer des caractéristiques hyperfréquences entre deux ports 13a et 13b de l'instrument de mesure 12. La plate-forme de test 5 peut comprendre des connecteurs 14a et 14b permettant de la relier aux ports 13a et 13b respectivement, par exemple par l'intermédiaire de câbles coaxiaux 15a et 15b. Les connecteurs 14a et 14b forment respectivement une première et une deuxième interfaces externes 16a, 16b de la plate-forme de test 5. De même, les empreintes conductrices 6a et 6b forment respectivement une première et une deuxième interfaces internes 17a, 17b. La plate-forme de test 5 comporte également une première ligne hyperfréquence 19a entre la première interface externe 16a et la première interface interne 17a et une deuxième ligne hyperfréquence 19b entre la deuxième interface externe 16b et la deuxième interface interne 17b. Les première et deuxième lignes hyperfréquences 19a, 19b sont par exemple des lignes microrubans, des lignes triplaques ou une combinaison de lignes microrubans et triplaques. Les lignes microrubans et triplaques sont également connues dans la littérature anglo-saxonne sous les dénominations respectives de lignes "microstrips" et de lignes "striplines". Un signal hyperfréquence peut ainsi transiter entre les ports 13a et 13b de l'instrument de mesure 12 en passant successivement par un câble coaxial 15a, le connecteur 14a, la première ligne hyperfréquence 19a, l'empreinte conductrice 6a, la bille 2a, le fil de connexion 11a, le composant hyperfréquence 8, le fil de connexion 11b, la bille 2b, l'empreinte conductrice 6b, la deuxième ligne hyperfréquence 19b, le connecteur 14b et le câble coaxial 15b. Un signal hyperfréquence peut bien évidemment transiter du port 13b au port 13a en empruntant le chemin inverse.

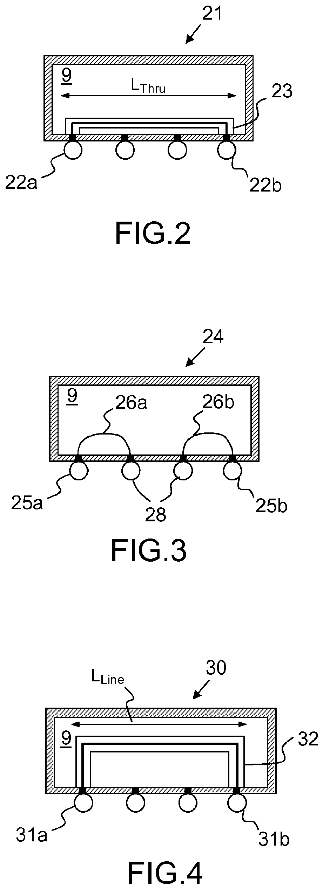

Selon le procédé de calibrage de l'invention on remplace les motifs étalons conventionnels Thru, Reflect et Line par des boîtiers étalons hyperfréquences remplissant des fonctions similaires, la plate-forme de test 5 étant adaptée en conséquence, comme décrit ci-dessus. Un premier boîtier hyperfréquence, appelé boîtier Thru 21, est représenté à la figure 2. Il comporte des accès hyperfréquences 22a et 22b et une ligne gravée 23 de longueur L_{Thru} reliant les accès hyperfréquences 22a et 22b. Un deuxième boîtier hyperfréquence, appelé boîtier Reflect 24, est représenté à la figure 3. Il comporte également des accès hyperfréquences 25a et 25b. En revanche, ces accès 25a et 25b sont court-circuités. Les courts-circuits sont par exemple réalisés par des fils de connexion 26a et 26b reliant les accès hyperfréquences 25a et 25b à un plan de masse, par exemple des billes 28 du boîtier Reflect 24. Les courts-circuits peuvent également être réalisés en retirant l'épargne entre les accès hyperfréquences 25a et 25b et le plan de masse auquel sont reliées les billes de masse 28, mettant ainsi les accès hyperfréquences 25a et 25b en contact avec le plan de masse. Un troisième boîtier hyperfréquence, appelé boîtier Line 30, est représenté à la figure 4. Il comporte des accès hyperfréquences 31a et 31b et une ligne gravée 32 de longueur L_{Line} reliant les accès hyperfréquences 31a et 31b. La longueur L_{Line} est généralement supérieure à la longueur L_{Thru}. La différence de longueur entre L_{Thru} et L_{Line} est dictée par la bande de fréquence dans laquelle opère le boîtier 1 hyperfréquence. Selon l'invention, le procédé de calibrage de la plate-forme de test 5 comprend les étapes suivantes :
- déterminer une première matrice de paramètres S, le boîtier Thru 21 étant connecté à la plate-forme de test 5 ;
- déterminer une deuxième matrice de paramètres S, le boîtier Reflect 24 étant connecté à la plate-forme de test 5 ;
- déterminer une troisième matrice de paramètres S, le boîtier Line 30 étant connecté à la plate-forme de test ;
- déterminer, à partir des première, deuxième et troisième matrices de paramètres S, des caractéristiques de la plate-forme de test 5.

Par connexion d'un boîtier 21, 24 ou 30 à la plate-forme de test 5, il faut entendre le contact électrique entre, d'une part, la première interface interne 17a de la plate-forme de test 5 et l'un des accès hyperfréquences 22a, 25a ou 31a des boîtiers 21, 24 et 30, et, d'autre part, la deuxième interface interne 17b de la plate-forme de test 5 et l'un des accès hyperfréquences 22b, 25b ou 31b.

L'utilisation de boîtiers Thru 21, Reflect 24 et Line 30 permet de conserver la même interface électrique entre chacun des boîtiers et la plate-forme de test 5. En particulier, les interfaces internes 17a et 17b de la plate-forme de test 5 et les accès hyperfréquences 22a, 22b, 25a, 25b, 31a et 31b peuvent être identiques pour chacun des boîtiers 21, 24 et 30. Selon une forme particulière de réalisation, les accès hyperfréquences 22a, 22b, 25a, 25b, 31a et 31b sont respectivement identiques aux accès hyperfréquences 7a et 7b du boîtier 1 à tester. En particulier, les accès hyperfréquences 22a, 25a, 31a d'une part et 22b, 25b, 31b d'autre part peuvent respectivement être formés par les billes 2a et 2b. En d'autres termes, les boîtiers 21, 24 et 30 comportent la même interface à matrice de billes que le boîtier 1 hyperfréquence. Les interfaces internes 17a et 17b de la plate-forme de test 5 comprennent alors les empreintes conductrices 6a et 6b.

Selon une forme de réalisation particulièrement avantageuse, les boîtiers Thru 21, Reflect 24 et Line 30 sont réalisés à partir du même modèle de boîtier que le boîtier 1 à tester. Par conséquent, les dimensions des boîtiers 1, 21, 24 et 30 et leurs accès hyperfréquences 7a, 7b, 22a, 22b, 25a, 25b, 31a et 31b peuvent être strictement identiques. Seul le composant 8 hyperfréquence ou le motif à l'intérieur des boîtiers 21, 24 et 30, autrement dit les lignes gravées 23 et 32 et les courts-circuits des accès hyperfréquences 25a et 25b, diffèrent selon les boîtiers.

Selon une forme particulière de réalisation, la connexion électrique entre les boîtiers 1, 21, 24 et 30 et la plate-forme de test 5 est assurée par pression. Cette pression est adaptée de façon à assurer un contact électrique entre chaque bille 2 et l'empreinte conductrice 6 correspondante sans pour autant déformer significativement les billes 2 ou les empreintes conductrices 6. Selon une autre forme de réalisation, la connexion électrique entre les boîtiers 1, 21, 24 et 30 et la plate-forme de test 5 est assurée via une lame intermédiaire en matériau élastique, par exemple décrite dans la demande de brevet FR 2 906 890. Cette lame intermédiaire permet d'assurer la continuité du signal hyperfréquence sans altérer l'interface à matrice de billes des boîtiers 1, 21, 24 et 30. Lesdits boîtiers peuvent alors être réutilisés.

Le procédé de calibrage selon l'invention présente notamment pour avantage que les caractéristiques de la plate-forme de test 5 peuvent être réutilisées pour plusieurs tests de boîtiers 1 hyperfréquences, dans la mesure où ces boîtiers 1 comportent la même interface à matrice de billes que celle des boîtiers étalons 21, 24 et 30. En outre, le procédé de calibrage est particulièrement fiable du fait que les caractéristiques de la plate-forme de test 5 incluent de manière inhérente les caractéristiques de son interface avec les différents boîtiers 1, 21, 24, 30. Par conséquent, les caractéristiques d'un boîtier 1 hyperfréquence à tester peuvent être déterminées au niveau de ses accès hyperfréquences 7a et 7b. Ces caractéristiques peuvent ensuite être exploitées dans un simulateur afin de simuler le comportement du boîtier 1 dans un environnement différent de celui dans lequel il a été mesuré.

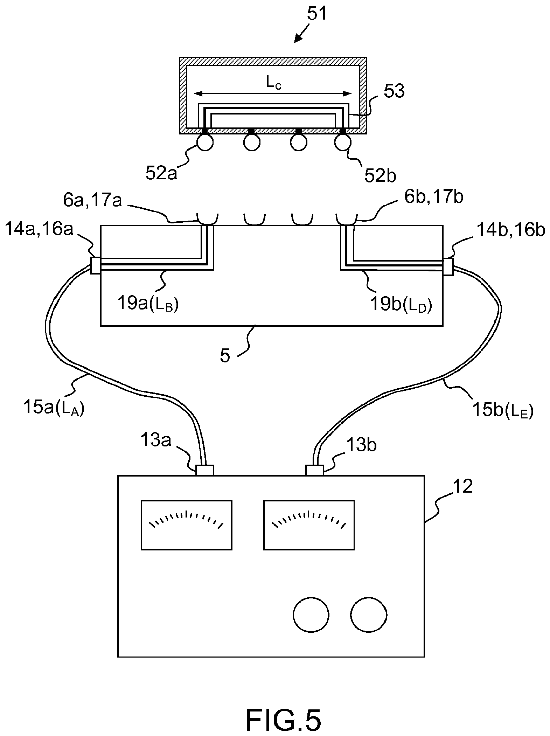

La précision de la détermination des caractéristiques des différents boîtiers 1, 21, 24, 30 dans leur environnement de test dépend notamment de la connaissance précise de la longueur électrique des lignes gravées 23 et 32 des boîtiers Thru 21 et Line 30. A cet effet, l'invention propose également un procédé de détermination d'une longueur électrique d'une ligne gravée d'un boîtier hyperfréquence. L'invention s'applique notamment, mais pas exclusivement, à la détermination de la longueur électrique des lignes gravées 23 et 32. Ce procédé de détermination est maintenant décrit en référence à la figure 5.

La figure 5 représente schématiquement un boîtier 51 hyperfréquence dans l'environnement de test de la figure 1. En particulier, l'environnement de test comprend la plate-forme de test 5 reliée à l'instrument de mesure 12 par les câbles coaxiaux 15a et 15b. Dans le cadre de l'invention, le boîtier 51 hyperfréquence correspond soit au boîtier Thru 21, soit au boîtier Reflect 24, soit encore au boîtier Line 30. Toutefois, on considère le cas général d'un boîtier 51 hyperfréquence comprenant deux accès hyperfréquences 52a et 52b aptes à être connectés à la première et à la deuxième interfaces internes 17a, 17b de la plate-forme de test 5 et une ligne gravée 53 de longueur électrique L_{C} reliant les accès hyperfréquences 52a et 52b. La longueur électrique d'une ligne peut être définie comme le rapport de sa longueur physique sur son coefficient de vélocité. Sur la figure 5, la longueur électrique L_{C} correspond sensiblement à la longueur physique de la ligne gravée 53. Cependant, cette représentation vise uniquement à faciliter la compréhension et n'implique pas que la longueur électrique L_{C} et la longueur physique de la ligne gravée 53 correspondent effectivement. Selon l'invention, le procédé comprend les étapes suivantes :
- déterminer une première longueur électrique L_{B} de la première ligne hyperfréquence 19a de la plate-forme de test 5 ;
- déterminer une deuxième longueur électrique L_{D} de la deuxième ligne hyperfréquence 19b de la plate-forme de test 5 ;
- déterminer une troisième longueur électrique L_{BCD} correspondant à la longueur électrique entre les interfaces externes 16a et 16b de la plate-forme de test 5 et incluant la longueur électrique L_{C} de la ligne gravée 53. En d'autres termes, la longueur électrique L_{BCD} correspond à la somme des longueurs électriques L_{B}, L_{C} et L_{D} ;
- déduire des première, deuxième et troisième longueurs électriques L_{B}, L_{D} et L_{BCD}, la longueur électrique L_{C} de la ligne gravée 53.

Selon une forme particulière de réalisation, la détermination de la première longueur électrique L_{B} comprend les sous-étapes suivantes :
- déterminer une longueur électrique L_{A} entre l'instrument de mesure 12 et la première interface externe 16a de la plate-forme de test 5 ;
- déterminer une longueur électrique L_{AB} entre l'instrument de mesure 12 et la première interface interne 17a de la plate-forme de test 5 ;
- déduire des longueurs électriques L_{A} et L_{AB} entre, d'une part, l'instrument de mesure 12 et la première interface externe 16a de la plate-forme de test 5 et, d'autre part, l'instrument de mesure 12 et la première interface interne 17a de la plate-forme de test 5, la première longueur électrique L_{B}.

Selon une forme particulière de réalisation, la détermination de la deuxième longueur électrique L_{D} comprend les sous-étapes suivantes :
- déterminer une longueur électrique L_{E} entre l'instrument de mesure 12 et la deuxième interface externe 16b de la plate-forme de test 5 ;
- déterminer une longueur électrique L_{DE} entre l'instrument de mesure 12 et la deuxième interface interne 17b de la plate-forme de test 5 ;
- déduire des longueurs électriques L_{E} et L_{DE} entre, d'une part, l'instrument de mesure 12 et la deuxième interface externe 16b de la plate-forme de test 5 et, d'autre part, l'instrument de mesure 12 et la deuxième interface interne 17b de la plate-forme de test 5, la deuxième longueur électrique L_{D}.

Selon une forme particulière de réalisation, la détermination de la longueur électrique L_{A} ou L_{E} entre l'instrument de mesure 12 et l'une des interfaces externes 16a ou 16b de la plate-forme de test 5 comprend une étape consistant à disposer un motif réfléchissant à une extrémité du câble coaxial 15a ou 15b devant être connectée à ladite interface externe 16a ou 16b de la plate-forme de test 5. Le motif réfléchissant correspond par exemple à un court-circuit ou à un circuit ouvert. Ainsi, un signal hyperfréquence incident est réfléchi à l'extrémité du câble coaxial 15a ou 15b et revient à l'instrument de mesure 12.

Selon une forme particulière de réalisation, la détermination de la longueur électrique L_{AB} ou L_{DE} entre l'instrument de mesure 12 et l'une des interfaces internes 17a ou 17b de la plate-forme de test 5 comprend une étape consistant à connecter aux interfaces internes 17a et 17b de la plate-forme de test 5 un boîtier hyperfréquence dont les accès hyperfréquences sont court-circuités. Dans un mode de réalisation, ce boîtier hyperfréquence est le boîtier Reflect 24. Ce mode de réalisation permet de disposer du même modèle de boîtier que les boîtiers Thru 21 et Line 30. En particulier, les interfaces électriques avec la plate-forme de test 5 sont identiques pour les différents boîtiers.

Selon une forme particulière de réalisation, la détermination de la troisième longueur électrique L_{BCD} comprend les sous-étapes suivantes :
- déterminer une longueur électrique L_{ABCD} entre l'instrument de mesure 12 et la deuxième interface externe 16b de la plate-forme de test 5, ladite longueur incluant la longueur électrique L_{C} de la ligne gravée 53 ;
- déterminer la longueur électrique L_{A} entre l'instrument de mesure 12 et la première interface externe 16a de la plate-forme de test 5 ;
- déduire de la longueur électrique L_{ABCD} entre l'instrument de mesure 12 et la deuxième interface externe 16b et de la longueur électrique L_{A} entre l'instrument de mesure 12 et la première interface externe 16a de la plate-forme de test 5, la troisième longueur électrique L_{BCD}.

Selon une forme particulière de réalisation, la détermination d'une longueur électrique L_{A}, L_{AB}, L_{ABCD}, L_{E} ou L_{DE} entre l'instrument de mesure 12 et l'une des interfaces 16a, 16b, 17a ou 17b de la plate-forme de test 5 comprend la mesure d'un signal hyperfréquence incident, la mesure d'un signal hyperfréquence réfléchi au niveau de l'une des interfaces 16a, 16b, 17a ou 17b, et la détermination du rapport entre le signal hyperfréquence incident et le signal hyperfréquence réfléchi. Ce rapport, appelé coefficient de réflexion, permet notamment de déterminer un déphasage entre les signaux hyperfréquences incident et réfléchi. A partir de ce déphasage et de la connaissance d'une vitesse de propagation des signaux hyperfréquences incident et réfléchi entre l'instrument de mesure 12 et l'une des interfaces 16a, 16b, 17a ou 17b, il est possible de déterminer la longueur électrique L_{A}, L_{AB}, L_{ABCD}, L_{E} ou L_{DE}.

## Revendications

1. Procédé de calibrage d'une plate-forme de test (5) apte à recevoir un boîtier (1) hyperfréquence, **caractérisé en ce qu'**il comprend les étapes suivantes :
- déterminer une première matrice de paramètres S, un premier boîtier hyperfréquence (21) dont les accès hyperfréquences (22a, 22b) sont reliés par une ligne gravée (23) de longueur L_{Thru} étant connecté à la plate-forme de test (5) ;
- déterminer une deuxième matrice de paramètres S, un deuxième boîtier hyperfréquence (24) dont les accès hyperfréquences (25a, 25b) sont court-circuités étant connecté à la plate-forme de test (5) ;
- déterminer une troisième matrice de paramètres S, un troisième boîtier hyperfréquence (30) dont les accès hyperfréquences (31a, 31b) sont reliés par une ligne gravée (32) de longueur L_{Line} supérieure à la longueur L_{Thru} étant connecté à la plate-forme de test (5) ;
- une étape de détermination, à partir des première, deuxième et troisième matrices de paramètres S, des caractéristiques de la plate-forme de test (5).

2. Procédé selon la revendication 1, **caractérisé en ce que** le boîtier (1) hyperfréquence à tester comprend un composant (8) hyperfréquence relié à deux accès hyperfréquences (7a, 7b), les accès hyperfréquences (22a, 22b, 25a, 25b, 31a, 31b) des premier, deuxième et troisième boîtiers hyperfréquences (21, 24, 30) étant identiques aux accès hyperfréquences (7a, 7b) du boîtier (1) hyperfréquence à tester.

3. Procédé selon l'une des revendications 1 ou 2, **caractérisé en ce que** les boîtiers hyperfréquences (1, 21, 24, 30) comportent une interface à matrice de billes.

4. Procédé selon l'une des revendications précédentes, **caractérisé en ce que** la connexion électrique entre les boîtiers hyperfréquences (1, 21, 24, 30) et la plate-forme de test (5) est assurée par pression.

5. Ensemble de boîtiers étalons hyperfréquences (21, 24, 30) aptes à être connectés sur une plate-forme de test (5) d'un boîtier (1) hyperfréquence, ledit boîtier (1) hyperfréquence comprenant un composant (8) hyperfréquence relié à deux accès hyperfréquences (7a, 7b), l'ensemble étant **caractérisé en ce qu'**il comprend :
- un premier boîtier hyperfréquence (21) dont les accès hyperfréquences (22a, 22b) sont reliés par une ligne gravée (23) de longueur L_{Thru}.
- un deuxième boîtier hyperfréquence (24) dont les accès hyperfréquences (25a, 25b) sont court-circuités,
- un troisième boîtier hyperfréquence (30) dont les accès hyperfréquences (31a, 31b) sont reliés par une ligne gravée (32) de longueur L_{Line} supérieure à la longueur L_{Thru},
- les accès hyperfréquences (22a, 22b, 25a, 25b, 31a, 31b) des premier, deuxième et troisième boîtiers hyperfréquences (21, 24, 30) étant identiques aux accès hyperfréquences (7a, 7b) du boîtier (1) hyperfréquence à tester.

6. Ensemble selon la revendication 5, **caractérisé en ce que** les boîtiers hyperfréquences (1, 21, 24, 30) comprennent une interface à matrice de billes.

7. Procédé de détermination d'une longueur électrique L_{C} d'une ligne gravée (53) reliant deux accès hyperfréquences (52a, 52b) d'un boîtier étalon hyperfréquence (51), les accès hyperfréquences (52a, 52b) du boîtier étalon (51) étant aptes à être connectés à une première et à une deuxième interfaces internes (17a, 17b) d'une plate-forme de test (5), la plate-forme de test (5) comprenant une première ligne hyperfréquence (19a) entre une première interface externe (16a) et la première interface interne (17a) et une deuxième ligne hyperfréquence (19b) entre une deuxième interface externe (16b) et la deuxième interface interne (17b), le procédé étant **caractérisé en ce qu'**il comprend les étapes suivantes :
- déterminer une première longueur électrique (L_{B}) de la première ligne hyperfréquence (19a) de la plate-forme de test (5) ;
- déterminer une deuxième longueur électrique (L_{D}) de la deuxième ligne hyperfréquence (19b) de la plate-forme de test (5) ;
- déterminer une troisième longueur électrique (L_{BCD}) correspondant à la longueur électrique entre les interfaces externes (16a, 16b) de la plate-forme de test (5) et incluant la longueur électrique (L_{C}) de la ligne gravée (53) reliant les deux accès hyperfréquences (52a, 52b) du boîtier étalon (51) ;
- déduire des première, deuxième et troisième longueurs électriques (L_{B}, L_{D}, L_{BCD}), la longueur électrique (L_{C}) de la ligne gravée (53), la détermination de la première longueur électrique (L_{B}) comprenant les sous-étapes suivantes :
- déterminer une longueur électrique (L_{A}) entre un instrument de mesure (12) et la première interface externe (16a) de la plate-forme de test (5);
- déterminer une longueur électrique (L_{AB}) entre l'instrument de mesure (12) et la première interface interne (17a) de la plate-forme de test (5) ;
- déduire des longueurs électriques (L_{A}, L_{AB}) entre, d'une part, l'instrument de mesure (12) et la première interface externe (16a) de la plate-forme de test (5) et, d'autre part, l'instrument de mesure (12) et la première interface interne (17a) de la plate-forme de test (5), la première longueur électrique (LB),
la détermination de la longueur électrique (L_{AB}) entre l'instrument de mesure (12) et la première interface interne (17a) de la plate-forme de test (5) comprenant une étape consistant à connecter aux interfaces internes (17a, 17b) de la plate-forme de test (5) un boîtier hyperfréquence (24) dont les accès hyperfréquences (25a, 25b) sont court-circuités.

8. Procédé selon la revendication 7, **caractérisé en ce que** la détermination de la deuxième longueur électrique (L_{D}) comprend les sous-étapes suivantes :
- déterminer une longueur électrique (L_{E}) entre un instrument de mesure (12) et la deuxième interface externe (16b) de la plate-forme de test (5);
- déterminer une longueur électrique (L_{DE}) entre l'instrument de mesure (12) et la deuxième interface interne (17b) de la plate-forme de test (5) ;
- déduire des longueurs électriques (L_{E}, L_{DE}) entre, d'une part, l'instrument de mesure (12) et la deuxième interface externe (16b) de la plate-forme de test (5) et, d'autre part, l'instrument de mesure (12) et la deuxième interface interne (17b) de la plate-forme de test (5), la deuxième longueur électrique (L_{D}).

9. Procédé selon l'une des revendications 7 ou 8, **caractérisé en ce que** la détermination de la longueur électrique (L_{A}, L_{E}) entre l'instrument de mesure (12) et une interface externe (16a, 16b) de la plate-forme de test (5) comprend une étape consistant à disposer un motif réfléchissant à une extrémité d'un câble coaxial (15a, 15b) devant être connectée à ladite interface externe (16a, 1 6b) de la plate-forme de test (5).

10. Procédé selon l'une des revendications 7 à 9, **caractérisé en ce que** la détermination de la longueur électrique (L_{DE}) entre l'instrument de mesure (12) et la deuxième interface interne (17b) de la plate-forme de test (5) comprend une étape consistant à connecter aux interfaces internes (17a, 17b) de la plate-forme de test (5) un boîtier hyperfréquence (24) dont les accès hyperfréquences (25a, 25b) sont court-circuités.

11. Procédé selon l'une des revendications 7 à 10, **caractérisé en ce que** la détermination de la troisième longueur électrique (L_{BCD}) comprend les sous-étapes suivantes :
- déterminer une longueur électrique (L_{ABCD}) entre un instrument de mesure (12) et la deuxième interface externe (16b) de la plate-forme de test (5), ladite longueur incluant la longueur électrique (L_{C}) de la ligne gravée (53) ;
- déterminer une longueur électrique (L_{A}) entre l'instrument de mesure (12) et la première interface externe (16a) de la plate-forme de test (5) ;
- déduire de la longueur électrique (L_{ABCD}) entre l'instrument de mesure (12) et la deuxième interface externe (16b) de la plate-forme de test (5) et de la longueur électrique (L_{A}) entre l'instrument de mesure (12) et la première interface externe (16a) de la plate-forme de test (5), la troisième longueur électrique (L_{BCD}).

## Patentansprüche

1. Verfahren zum Kalibrieren einer Testplattform (5), die ein Mikrowellengehäuse (1) aufnehmen kann, **dadurch gekennzeichnet, dass** es die folgenden Schritte beinhaltet:
- Bestimmen einer ersten Matrix von Parametern S, wobei ein erstes Mikrowellengehäuse (21), dessen Mikrowelleneingänge (22a, 22b) durch eine geätzte Leitung (23) der Länge L_{Thru} verbunden sind, mit der Testplattform (5) verbunden ist;
- Bestimmen einer zweiten Matrix von Parametern S, wobei ein zweites Mikrowellengehäuse (24), dessen Mikrowelleneingänge (25a, 25b) kurzgeschlossen sind, mit der Testplattform (5) verbunden ist;
- Bestimmen einer dritten Matrix von Parametern S, wobei ein drittes Mikrowellengehäuse (30), dessen Mikrowelleneingänge (31a, 31b) durch eine geätzte Leitung (32) der Länge L_{Line} verbunden sind, die größer ist als die Länge L_{Thru}, mit der Testplattform (5) verbunden ist;
- einen Schritt des Bestimmens der Charakteristiken der Testplattform (5) auf der Basis der ersten, zweiten und dritten Matrix von Parametern S.

2. Verfahren nach Anspruch 1, **dadurch gekennzeichnet, dass** das zu testende Mikrowellengehäuse (1) eine Mikrowellenkomponente (8) umfasst, verbunden mit zwei Mikrowelleneingängen (7a, 7b), wobei die Mikrowelleneingänge (22a, 22b, 25a, 25b, 31a, 31b) des ersten, zweiten und dritten Mikrowellengehäuses (21, 24, 30) mit den Mikrowelleneingängen (7a, 7b) des zu testenden Mikrowellengehäuses (1) identisch sind.

3. Verfahren nach Anspruch 1 oder 2, **dadurch gekennzeichnet, dass** die Mikrowellengehäuse (1, 21, 24, 30) eine Kugelgitteranordnungsschnittstelle umfassen.

4. Verfahren nach einem der vorherigen Ansprüche, **dadurch gekennzeichnet, dass** die elektrische Verbindung zwischen den Mikrowellengehäusen (1, 21, 24, 30) und der Testplattform (5) durch Druck bereitgestellt wird.

5. Satz von Standardmikrowellengehäusen (21, 24, 30), die mit einer Testplattform (5) eines Mikrowellengehäuses (1) verbunden werden können, wobei das Mikrowellengehäuse (1) eine mit zwei Mikrowelleneingängen (7a, 7b) verbundene Mikrowellenkomponente (8) umfasst, wobei die Baugruppe **dadurch gekennzeichnet ist, dass** sie Folgendes umfasst:
- ein erstes Mikrowellengehäuse (21), dessen Mikrowelleneingänge (22a, 22b) durch eine geätzte Leitung (23) der Länge L_{Thru} verbunden sind;
- ein zweites Mikrowellengehäuse (24), dessen Mikrowelleneingänge (25a, 25b) kurzgeschlossen sind;
- ein drittes Mikrowellengehäuse (30), dessen Mikrowelleneingänge (31a, 31b) durch eine geätzte Leitung (32) der Länge L_{Line}, die größer ist als die Länge L_{Thru}, verbunden sind;
- wobei die Mikrowelleneingänge (22a, 22b, 25a, 25b, 31a, 31b) des ersten, zweiten und dritten Mikrowellengehäuses (21, 24, 30) mit den Mikrowelleneingängen (7a, 7b) des zu testenden Mikrowellengehäuses (1) identisch sind.

6. Satz nach Anspruch 5, **dadurch gekennzeichnet, dass** die Mikrowellengehäuse (1, 21, 24, 30) eine Kugelgitteranordnungsschnittstelle umfassen.

7. Verfahren zum Bestimmen einer elektrischen Länge L_{C} einer geätzten Leitung (53), die zwei Mikrowelleneingänge (52a, 52b) eines Standardmikrowellengehäuses (51) verbindet, wobei die Mikrowelleneingänge (52a, 52b) des Standardpakets (51) mit einer ersten und einer zweiten internen Schnittstelle (17a, 17b) einer Testplattform (5) verbunden werden können, wobei die Testplattform (5) eine erste Mikrowellenleitung (19a) zwischen einer ersten externen Schnittstelle (16a) und der ersten internen Schnittstelle (17a) und eine zweite Mikrowellenleitung (19b) zwischen einer zweiten externen Schnittstelle (16b) und der zweiten internen Schnittstelle (17b) umfasst, wobei das Verfahren **dadurch gekennzeichnet ist, dass** es die folgenden Schritte beinhaltet:
- Bestimmen einer ersten elektrischen Länge (L_{B}) der ersten Mikrowellenleitung (19a) der Testplattform (5);
- Bestimmen einer zweiten elektrischen Länge (L_{D}) der zweiten Mikrowellenleitung (19b) der Testplattform (5);
- Bestimmen einer dritten elektrischen Länge (L_{BCD}), die der elektrischen Länge zwischen den externen Schnittstellen (16a, 16b) der Testplattform (5) entspricht, und die die elektrische Länge (L_{C}) der geätzten Leitung (53), die die zwei Mikrowelleneingänge (52a, 52b) des Standardpakets (51) miteinander verknüpft, einschließt;
- Ableiten der elektrischen Länge (L_{C}) der geätzten Leitung (53) von der ersten, zweiten und dritten elektrischen Länge (L_{B}, L_{D}, L_{BCD}), wobei das Bestimmen der ersten elektrischen Länge (L_{B}) die folgenden Unterschritte beinhaltet:
- Bestimmen einer elektrischen Länge (L_{A}) zwischen einem Messinstrument (12) und der ersten externen Schnittstelle (16a) der Testplattform (5);
- Bestimmen einer elektrischen Länge (L_{AB}) zwischen dem Messinstrument (12) und der ersten internen Schnittstelle (17a) der Testplattform (5);
- Ableiten der ersten elektrischen Länge (L_{B}) von den elektrischen Längen (L_{A}, L_{AB}) zwischen einerseits dem Messinstrument (12) und der ersten externen Schnittstelle (16a) der Testplattform (5) und andererseits dem Messinstrument (12) und der ersten internen Schnittstelle (17a) der Testplattform (5);
wobei das Bestimmen der elektrischen Länge (L_{AB}) zwischen dem Messinstrument (12) und der ersten internen Schnittstelle (17a) der Testplattform (5) einen Schritt des Verbindens eines Mikrowellengehäuses (24) beinhaltet, dessen Mikrowelleneingänge (25a, 25b) kurzgeschlossen sind, mit den internen Schnittstellen (17a, 17b) der Testplattform (5).

8. Verfahren nach Anspruch 7, **dadurch gekennzeichnet, dass** das Bestimmen der zweiten elektrischen Länge (L_{D}) die folgenden Unterschritte beinhaltet:
- Bestimmen einer elektrischen Länge (L_{E}) zwischen einem Messinstrument (12) und der zweiten externen Schnittstelle (16b) der Testplattform (5);
- Bestimmen einer elektrischen Länge (L_{DE}) zwischen dem Messinstrument (12) und der zweiten internen Schnittstelle (17b) der Testplattform (5);
- Ableiten der zweiten elektrischen Länge (L_{D}) von den elektrischen Längen (L_{E}, L_{DE}) zwischen einerseits dem Messinstrument (12) und der zweiten externen Schnittstelle (16b) der Testplattform (5) und andererseits dem Messinstrument (12) und der zweiten internen Schnittstelle (17b) der Testplattform (5).

9. Verfahren nach Anspruch 7 oder 8, **dadurch gekennzeichnet, dass** das Bestimmen der elektrischen Länge (L_{A}, L_{E}) zwischen dem Messinstrument (12) und einer externen Schnittstelle (16a, 16b) der Testplattform (5) einen Schritt des Anordnens eines reflektierenden Musters an einem Ende eines Koaxialkabels (15a, 15b) beinhaltet, das mit der externen Schnittstelle (16a, 16b) der Testplattform (5) zu verbinden ist.

10. Verfahren nach einem der Ansprüche 7 bis 9, **dadurch gekennzeichnet, dass** das Bestimmen der elektrischen Länge (L_{DE}) zwischen dem Messinstrument (12) und der zweiten internen Schnittstelle (17b) der Testplattform (5) einen Schritt des Verbindens eines Mikrowellengehäuses (24), dessen Mikrowelleneingänge (25a, 25b) kurzgeschlossen sind, mit den internen Schnittstellen (17a, 17b) der Testplattform (5) beinhaltet.

11. Verfahren nach einem der Ansprüche 7 bis 10, **dadurch gekennzeichnet, dass** das Bestimmen der dritten elektrischen Länge (L_{BCD}) die folgenden Teilschritte beinhaltet:
- Bestimmen einer elektrischen Länge (L_{ABCD}) zwischen einem Messinstrument (12) und der zweiten externen Schnittstelle (16b) der Testplattform (5), wobei die Länge die elektrische Länge (L_{C}) der geätzten Leitung (53) beinhaltet;
- Bestimmen einer elektrischen Länge (L_{A}) zwischen dem Messinstrument (12) und der ersten externen Schnittstelle (16a) der Testplattform (5);
- Ableiten der dritten elektrischen Länge (L_{BCD}) von der elektrischen Länge (L_{ABCD}) zwischen dem Messinstrument (12) und der zweiten externen Schnittstelle (16b) der Testplattform (5) und von der elektrischen Länge (L_{A}) zwischen dem Messinstrument (12) und der ersten externen Schnittstelle (16a) der Testplattform (5).

## Claims

1. A method for calibrating a test platform (5) capable of receiving a microwave package (1), **characterised in that** it comprises the following steps:
- determining a first array of parameters S, with a first microwave package (21), the microwave inletports (22a, 22b) of which are connected by an etched line (23) of length L_{Thru}, being connected to the test platform (5);
- determining a second array of parameters S, with a second microwave package (24), the microwave inlet ports (25a, 25b) of which are short-circuited, being connected to the test platform (5);
- determining a third array of parameters S, with a third microwave package (30), the microwave inlet ports (31a, 31b) of which are connected by an etched line (32) of length L_{Line} greater than the length L_{Thru}, being connected to the test platform (5);
- a step of determining the characteristics of the test platform (5) based on the first, second and third arrays of parameters S.

2. The method as claimed in claim 1, **characterised in that** the microwave package (1) to be tested comprises a microwave component (8) connected to two microwave inlet ports (7a, 7b), the microwave inlet ports (22a, 22b, 25a, 25b, 31a, 31b) of the first, second and third microwave packages (21, 24, 30) being identical to the microwave inlet ports (7a, 7b) of the microwave package (1) to be tested.

3. The method as claimed in claim 1 or 2, **characterised in that** the microwave packages (1, 21, 24, 30) comprise a ball grid array interface.

4. The method as claimed in any of the preceding claims, **characterised in that** the electrical connection between the microwave packages (1, 21, 24, 30) and the test platform (5) is provided by pressure.

5. A set of standard microwave packages (21, 24, 30) capable of being connected to a test platform (5) of a microwave package (1), said microwave package (1) comprising a microwave component (8) connected to two microwave inlet ports (7a, 7b), the assembly being **characterised in that** it comprises:
- a first microwave package (21), the microwave inlet ports (22a, 22b) of which are connected by an etched line (23) of length L_{Thru};
- a second microwave package (24), the microwave inlet ports (25a, 25b) of which are short-circuited;
- a third microwave package (30), the microwave inlet ports (31a, 31b) of which are connected by an etched line (32) of length L_{Line} greater than the length L_{Thru};
- the microwave inlet ports (22a, 22b, 25a, 25b, 31a, 31b) of the first, second and third microwave packages (21, 24, 30) being identical to the microwave inlet ports (7a, 7b) of the microwave package (1) to be tested.

6. The set as claimed in claim 5, **characterised in that** the microwave packages (1, 21, 24, 30) comprise a ball grid array interface.

7. A method for determining an electrical length L_{C} of an etched line (53) connecting two microwave inlet ports (52a, 52b) of a standard microwave package (51), the microwave inlet ports (52a, 52b) of the standard package (51) being able to be connected to a first and to a second internal interface (17a, 17b) of a test platform (5), the test platform (5) comprising a first microwave line (19a) between a first external interface (16a) and the first internal interface (17a) and a second microwave line (19b) between a second external interface (16b) and the second internal interface (17b), the method being **characterised in that** it comprises the following steps:
- determining a first electrical length (L_{B}) of the first microwave line (19a) of the test platform (5);
- determining a second electrical length (L_{D}) of the second microwave line (19b) of the test platform (5);
- determining a third electrical length (L_{BCD}) corresponding to the electrical length between the external interfaces (16a, 16b) of the test platform (5) and including the electrical length (L_{C}) of the etched line (53) linking the two microwave inlet ports (52a, 52b) of the standard package (51);
- deducing the electrical length (L_{C}) of the etched line (53) from the first, second and third electrical lengths (L_{B}, L_{D}, L_{BCD}), with the determining of the first electrical length (L_{B}) comprising the following sub-steps:
- determining an electrical length (L_{A}) between a measurement instrument (12) and the first external interface (16a) of the test platform (5);
- determining an electrical length (L_{AB}) between the measurement instrument (12) and the first internal interface (17a) of the test platform (5);
- deducing the first electrical length (L_{B}) from the electrical lengths (L_{A}, L_{AB}) between, on the one hand, the measurement instrument (12) and the first external interface (16a) of the test platform (5) and, on the other hand, the measurement instrument (12) and the first internal interface (17a) of the test platform (5);
with the determining of the electrical length (L_{AB}) between the measurement instrument (12) and the first internal interface (17a) of the test platform (5) comprising a step involving connecting a microwave package (24), the microwave inlet ports (25a, 25b) of which are short-circuited, to the internal interfaces (17a, 17b) of the test platform (5).

8. The method as claimed in claim 7, **characterised in that** determining the second electrical length (L_{D}) comprises the following sub-steps:
- determining an electrical length (L_{E}) between a measurement instrument (12) and the second external interface (16b) of the test platform (5);
- determining an electrical length (L_{DE}) between the measurement instrument (12) and the second internal interface (17b) of the test platform (5);
- deducing the second electrical length (L_{D}) from the electrical lengths (L_{E}, L_{DE}) between, on the one hand, the measurement instrument (12) and the second external interface (16b) of the test platform (5) and, on the other hand, the measurement instrument (12) and the second internal interface (17b) of the test platform (5).

9. The method as claimed in claim 7 or 8, **characterised in that** determining the electrical length (L_{A}, L_{E}) between the measurement instrument (12) and an external interface (16a, 16b) of the test platform (5) comprises a step involving disposing a reflective pattern at an end of a coaxial cable (15a, 15b) that is to be connected to said external interface (16a, 16b) of the test platform (5).

10. The method as claimed in any one of claims 7 to 9, **characterised in that** determining the electrical length (L_{DE}) between the measurement instrument (12) and the second internal interface (17b) of the test platform (5) comprises a step involving connecting a microwave package (24), the microwave inlet ports (25a, 25b) of which are short-circuited, to the internal interfaces (17a, 17b) of the test platform (5).

11. The method as claimed in any one of claims 7 to 10, **characterised in that** determining the third electrical length (L_{BCD}) comprises the following sub-steps:
- determining an electrical length (L_{ABCD}) between a measurement instrument (12) and the second external interface (16b) of the test platform (5), said length including the electrical length (L_{C}) of the etched line (53);
- determining an electrical length (L_{A}) between the measurement instrument (12) and the first external interface (16a) of the test platform (5);
- deducing the third electrical length (L_{BCD}) from the electrical length (L_{ABCD}) between the measurement instrument (12) and the second external interface (16b) of the test platform (5) and from the electrical length (L_{A}) between the measurement instrument (12) and the first external interface (16a) of the test platform (5).
